(19) Europäisches Patentamt
European Patent Office
Office européen des brevets

(11) **EP 2 252 857 B1**

(12) **EUROPÄISCHE PATENTSCHRIFT**

(45) Veröffentlichungstag und Bekanntmachung des Hinweises auf die Patenterteilung:
**22.06.2011 Patentblatt 2011/25**

(21) Anmeldenummer: **09718996.3**

(22) Anmeldetag: **10.03.2009**

(51) Int Cl.:
*G01B 11/26* (2006.01)     *G01D 5/26* (2006.01)
*G01D 5/30* (2006.01)     *G02B 26/08* (2006.01)
*G02B 27/64* (2006.01)     *G03F 7/20* (2006.01)

(86) Internationale Anmeldenummer:
**PCT/EP2009/001705**

(87) Internationale Veröffentlichungsnummer:
**WO 2009/112239 (17.09.2009 Gazette 2009/38)**

(54) **Verfahren und Anordnung zur Verschiebung**

Method and arrangement for displacement

Procédé et dispositif de déplacement

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **10.03.2008 DE 102008013504**

(43) Veröffentlichungstag der Anmeldung:
**24.11.2010 Patentblatt 2010/47**

(73) Patentinhaber: **Heidelberg Instruments Mikrotechnik GmbH
69126 Heidelberg (DE)**

(72) Erfinder:
• **FANGERAU, Michael
69181 Leimen (DE)**

• **MANGOLD, Alexander
67071 Ludwigshafen (DE)**
• **KAPLAN, Roland
69126 Heidelberg (DE)**

(74) Vertreter: **Schmitt, Meinrad et al
Reble, Klose & Schmitt GbR
Patente + Marken
Postfach 12 15 19
68066 Mannheim (DE)**

(56) Entgegenhaltungen:
**EP-A- 1 107 068     DD-A1- 239 658
DE-A1- 3 820 170     US-A- 5 625 436**

EP 2 252 857 B1

**Beschreibung**

Die Erfindung bezieht sich auf ein Verfahren zur Verschiebung eines durch elektromagnetische Strahlung übertragenen Bildes gemäß dem im Oberbegriff des Patentanspruchs 1 angegebenen Merkmalen. Ferner bezieht sich die Erfindung auf eine Anordnung zur Durchführung des Verfahrens.

Aus der Patentschrift US 5 625 436 sind ein derartiges Verfahren sowie eine Anordnung bekannt, um durch elektromagnetische Strahlung Bilder bzw. Abbildungen entsprechend einer Maske auf eine fotoempfindliche Schicht eines Substrats zu übertragen. Im Strahlengang zwischen der Maske und dem Substrat sind als planparallele Glasplatten ausgebildete Körper vorhanden, welche um Achsen drehbar angeordnet sind und deren Brechungsindex verschieden vom Brechungsindex der umgebenden Luft ist. Die genannten Körper sind mittels geeigneter Antriebe entsprechend der vorgesehenen Bildverschiebung einstellbar.

Ein elektromagnetischer Strahl, welcher unter einem Winkel auf den strahlungsbrechenden Körper bzw. auf ein in ein Umgebungsmedium eingebettetes Medium anderer Dichte mit einer insbesondere planen Oberfläche auftritt, wird bekanntlich beim Eintritt in das Medium gebrochen. Ist die gegenüberliegende Grenzfläche des Körpers bzw. Mediums parallel zur Eintrittsfläche, so wird der Strahl beim Austritt aus dem Medium aus Symmetriegründen wieder um den gleichen Winkel in die Gegenrichtung gebrochen. Dadurch erfährt der Strahl einen Versatz, dessen Betrag vom Winkel zwischen dem Strahl und dem Körper bzw. Medium abhängt, welches insbesondere als eine planparallele Glasplatte ausgebildet ist. Diese Eigenschaft wird zur einstellbaren seitlichen Verschiebung der mittels eines elektromagnetischen Strahls erzeugten Abbildung genutzt, wobei das Medium, insbesondere die planparallele, Platte drehbar im genannten Strahl angeordnet wird. Die Genauigkeit, mit welcher die Abbildungslage auf diese Weise eingestellt werden kann, ist dabei davon abhängig, wie präzise und reproduzierbar die Winkeleinstellung des Körpers, des Mediums bzw. der Platte ist.

Ferner ist aus der Patentschrift US 5 218 415 eine Vorrichtung zur optischen Messung der Neigung einer Oberfläche eines Wafers bekannt, wobei ein Lichtstrahl an einer Oberfläche des Wafers reflektiert wird. Die entsprechend der Neigung des Wafers in unterschiedlichen Richtungen reflektierten Strahlen werden über eine Linse parallel zueinander ausgerichtet und einer Einheit zur Erfassung des Neigungswinkels zugeführt.

Des Weiteren sind aus der Offenlegungsschrift DE 38 20 170 A1 und der Patentschrift DD 239 658 A1 Meßgeber bekannt, welche als Interferometer ausgebildet sind und einem strahlungsbrechenden Körper enthalten. Der strahlungsbrechende Körper ist hierbei im Strahlengang einer Referenzstrahlung derart angeordnet, dass der Einfallswinkel der Strahlung auf die Oberfläche des strahlungsbrechenden Körpers aufgrund dessen Bewegungen veränderbar ist, wobei durch Überlagerung der den genannten Körper durchdringenden Strahlung und der Referenzstrahlung infolge der sich ergebenden Interferenz Signale entsprechend der Bewegungen des genannten Körpers erzeugt werden.

Hiervon ausgehend liegt der Erfindung die Aufgabe zugrunde, das Verfahren und die Anordnung der genannten Art mit einem geringen Aufwand dahingehend weiterzubilden, dass eine optimierte und/oder präzise Bildverschiebung erreicht wird. Weiterhin sollen eine hoch auflösende Einstellung der Bildlage und/oder eine hoch auflösende Kontrolle der Drehung des zur Bildverschiebung vorgesehenen strahlungsbrechenden Körpers erreicht werden. Das Verfahren soll in einfacher Weise und mit reproduzierbaren Werten durchführbar sein und die Anordnung soll einen geringen konstruktiven Aufwand erfordern.

Die Lösung dieser Aufgabe erfolgt hinsichtlich des Verfahrens gemäß den Merkmalen des Patentanspruchs 1 und weiterhin gemäß den Merkmalen des auf die Vorrichtung gerichteten Patentanspruchs.

Die vorgeschlagene Methode und die zur Durchführung derselben vorgeschlagene Anordnung ermöglichen eine hoch auflösende und präzise Einstellung der Bildlage, wobei mittels eines Interferometers eine hoch auflösende Kontrolle und/oder Regelung der Drehung und/oder Einstellung des strahlungsbrechenden Körpers erfolgt. Das Verfahren und die Anordnung nutzen den gleichen Effekt des Versatzes sowohl zur Steuerung der Lage des Abbildungsstrahls als auch zur Messung der Winkeländerung und/oder des Winkels des Körpers. Die Kombination der Bildverschiebung einerseits und der Messung andererseits erfolgt gemeinsam und/oder mit dem gleichen strahlungsbrechenden Körper, wobei für die Messung der mittels der Interferometereinheit zusätzlich erzeugte Strahl, insbesondere elektromagnetischer Strahl, durch den strahlungsbrechenden Körper hindurch auf eine reflektierende, insbesondere ebene Fläche, insbesondere eines Planspiegels gerichtet wird und von dort auf die Interferometereinheit reflektiert wird und somit ein Signal entsprechend der Einstellung oder Veränderung des Drehwinkels des genannten Körpers erzeugt wird.

In bevorzugter Weise treffen der abbildende Strahl und/oder der Strahl der Interferometereinheit den strahlungsbrechenden Körper zumindest näherungsweise im gleichen Bereich und/oder der gleichen Stelle seiner Oberfläche und/oder zumindest näherungsweise im Wesentlichen auf seiner Drehachse. Es ist darüber hinaus von besonderer Bedeutung, dass der Messstrahl der Interferometereinheit teilweise an der Eintrittsfläche und/oder der Oberfläche des drehbaren strahlungsbrechenden Körpers reflektiert und auf eine Messeinrichtung geleitet wird, welche ein insbesondere elektrisches Signal in Abhängigkeit der Einfallsrichtung und/oder Position des elektromagnetischen Messstrahls liefert. Die Messeinrichtung, welche insbesondere als Positionsdetektor ausgebildet ist oder einen solchen enthält, liefert erfindungsgemäß mit hoher Genauigkeit einen definierten Ausgangspunkt und/oder ein Referenzsignal des Drehwinkels und/oder der Position des strahlungsbrechenden Körpers. Somit ist eine absolute Einstellung des Drehwinkels des Körpers ermöglicht und mithin wird eine absolute Verschiebung und/oder eine Verschiebung mit einem absoluten vorgegebenen Wert der Abbildung und/oder des zu verschiebenden Bildes ermöglicht. In bevorzugter Weise wird der gleiche Körper für drei Funktionen verwendet, nämlich die Bildverschiebung, die Winkelmessung und die Erfassung des Referenzwerts. Sowohl der Referenzwert als auch die Messsignale der Winkelmessung werden in einem geschlossenen Regelkreis zur Einstellung und/oder Kontrolle der absoluten Bildverschiebung in Abhängigkeit eines vorgebbaren Sollwerts verwendet.

Die absolute Bildverschiebung erfolgt bevorzugt in einer Achse und/oder Richtung senkrecht zum abbildenden Strahl mittels der kontrollierten und/oder geregelten Drehung des strahlungsbrechenden Körpers, und zwar unter Berücksichtigung des und/oder ausgehend von dem erfindungsgemäß vorgegebenen und/oder gemessenen und/oder definierten Nullpunkt bzw. Referenzwert. Erfindungsgemäß wird zum einen eine hoch auflösende Kontrolle und/oder Regelung der Drehung des strahlungsbrechenden Körpers zur Bildverschiebung durchgeführt und zum anderen mit hoher Genauigkeit ein definierter Referenzwert und/oder Ausgangspunkt für die Drehung bzw. Drehungen des Körpers vorgegeben und/oder berücksichtigt, wobei ausgehend von dem Ausgangspunkt und/oder Referenzwert absolute Bewegungen des Körpers ermöglicht werden.

Das vorgeschlagene Verfahren und die Anordnung nutzen den gleichen Effekt des Versatzes, welcher zur Steuerung der Lage des Abbildungsstrahles genutzt wird auch zur Messung der Winkeländerung des Körpers insbesondere während eines Einstellvorgangs, wobei interferometrisch die Änderung der Weglänge des durch den Körper verlaufenden Messstrahls vermessen wird. In bevorzugter Weise sind der Abbildungsstrahl und/oder der Messstrahl Laserstrahlen. Es sei angemerkt, dass das Verfahren und die Anordnung im Gegensatz zu einer Messung, beispielsweise unter Verwendung einer an einer Drehwelle des den Körper bewegenden Antriebs oder Motors befestigten Encoderscheibe, eine direkte Messung ermöglichen, da der aktive strahlungsbrechende Körper auch als Meßwertgeber dient, wodurch in vorteilhafter Weise eine hoch auflösende Erfassung und/oder Bestimmung der Winkeländerung während der Bewegung ermöglicht wird. Weiterhin sei festgehalten, dass zugleich die Lage des an der Oberfläche des Körpers reflektierten Strahls zur Festlegung des absoluten Nullpunkts oder Referenzwerts für die Bewegung des Körpers genutzt wird.

Besondere Ausgestaltungen und Weiterbildungen der Erfindung sind in den Unteransprüchen und der nachfolgenden Beschreibung eines besonderen Ausführungsbeispiels angegeben.

Anhand des in der Zeichnung beispielshaft dargestellten Aufbaus werden im Folgenden das Verfahren und die Anordnung der absoluten Bildverschiebung und insbesondere die dabei zum Einsatz kommenden Messmethoden zur Position des insbesondere als planparallele Glasplatte ausgebildeten strahlungsbrechenden Körpers erläutert, ohne dass dadurch eine Einschränkung der Erfindung erfolgt. Es zeigen:

Fig. 1      eine schematische Darstellung der Gesamtanordnung einschließlich der in den Ansprüchen angegebenen zusätzlichen Komponenten,

Fig. 2, 3   zwei Skizzen zur Erläuterung der verwendeten Formelzeichen zur Be- rechnung der Weglängenänderung des Strahls, der zur Messung der Winkeländerung der planparallelen Platte genutzt wird.

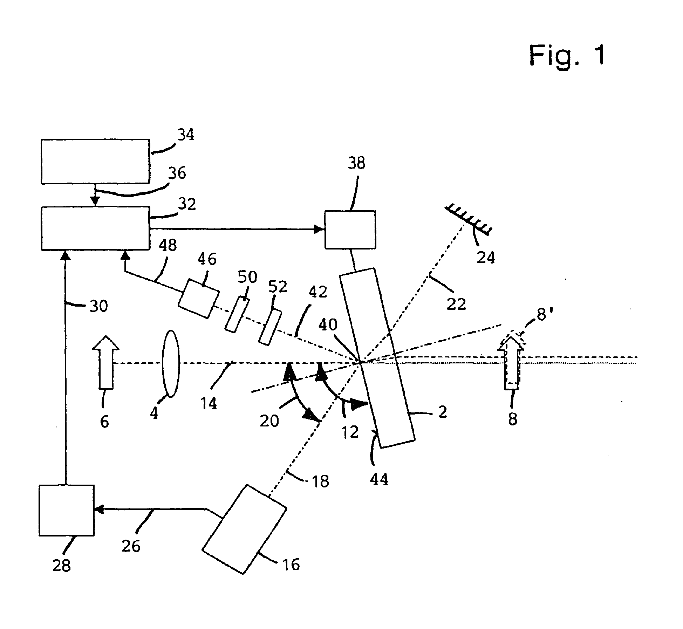

In der beispielshaften Anordnung gemäß Fig. 1 dient als strahlungsbrechender Körper die planparallele Platte 2 zur seitlichen Lageregelung der mittels einer Abbildungsoptik 4 erzeugten Abbildung eines Objektes 6. Das Objekt und/oder Bild wird mittels einer hier nicht weiter dargestellten Strahlungsquelle, insbesondere eines Lasers, und einer bevorzugt programmierbaren Maske eines Fotolithographie-Systems erzeugt und beispielsweise als Bild 8 auf einem Substrat bzw. Wafer abgebildet. Die seitliche Lage hängt von der Winkelposition 12 der planparallelen Platte 2 bezüglich der elektromagnetischen Strahlung bzw. des Abbildungsstrahls 14 ab. Beträgt der Winkel 12 beispielsweise 90°, so wird der Abbildungsstrahl 12 in der Platte 2 nicht gebrochen und das Bild 8 nimmt die mit ausgezogener Linie dargestellte Position ein. Ist hingegen die Platte 12, wie dargestellt, gekippt, so gilt die mit gestrichelter Linie angedeutete Lage 8'. Um die jeweilige Winkelposition hoch auflösend und absolut für die Regelung bestimmen zu können, ist eine Interferometeranordnung oder Interferometereinheit 16 vorgesehen, mittels welcher ein Messstrahl 18 unter einem vorgegebenen Winkel 20 auf die Platte 2 gerichtet wird. Die Interferometereinheit 16 enthält eine weitere Strahlungsquelle, insbesondere einen weiteren Laser, eine Interferometeroptik und einen Detektor.

Ein erster Strahlanteil 22 läuft durch die Platte 2 hindurch und trifft auf eine reflektierende Fläche und/oder einen Planspiegel 24 und wird in sich selbst und/oder auf dem gleichen Weg reflektiert und gelangt zurück zur Interferometeranordnung 16. Infolge der Änderung der optischen Weglänge des Messstrahls 18 aufgrund einer Drehung der Platte 2 werden mit der Interferometeranordnung 16 interferometrische Signale 26 erzeugt, welche einer Interferometerelektronik 28 zugeführt werden, welche insbesondere als Zähleinheit ausgebildet ist. Die Ausgangssignale 30 der Elektronikeinheit 28 werden einer Auswertungselektronik 32 zugeführt und zur Bestimmung des Winkels 12 und/oder Winkeländerung während einer Bewegung, insbesondere Drehung der Platte 2 genutzt. Mittels eines externen Sollwertgenerators 34 wird ein Sollwertsignal in die Auswertungselektronik 32 eingegeben. Die Regelabweichung aus dem Sollwertsignal 36 und dem Istwertsignal 30 wird auf eine Ansteuerungselektronik oder Drehungselektronik 38 mit einem Drehantrieb für die Platte 2 gegeben. Es ist somit ein geschlossener Regelkreis geschaffen, wobei die Auswertungselektronik 32 den Regler bildet und/oder insbesondere den Sollwert-Istwertvergleich ermöglicht. Die Platte 2 ist mittels des Drehantriebs um eine Achse 40 drehbar, welche bevorzugt vom Abbildungsstrahl 14 und dem Meßstrahl 18 geschnitten wird. Die Achse 40 verläuft im Wesentlichen orthogonal zur Zeichenebene.

Ein zweiter Strahlanteil 42 des Messstrahls 18 wird an der Oberfläche 44 reflektiert und auf eine Messeinrichtung und/oder einen Positionsdetektor 46 gelenkt. Der Positionsdetektor 46 enthält beispielsweise eine Differenzdiode, deren Signalhöhe und Signalpolarität von der Lage des Strahlanteils 42 relativ zum Mittelpunkt abhängt. Das derart erhaltene Positionssignal 48 wird gleichfalls der Auswertungselektronik und/oder dem Regler 32 zugeführt. Mittels des Positionsdetektors 46 wird erfindungsgemäß ein Referenzsignal und/oder ein definierter Nullpunkt für eine definierte und/oder vorgegebene Position der Platte 2 erzeugt. Unter Berücksichtigung des derart ermittelten Referenzwerts und/oder des derart definierten absoluten Nullpunkts für die Bewegung der Platte 2 wird somit in Abhängigkeit des oder der insbesondere mittels des externen Sollwertgenerators 34 eingegebenen Sollwertsignale 36 die kontrollierte oder geregelte Drehung der planparallelen Platte 2 durchgeführt, und zwar ausgehend von dem mittels und/oder über die Messeinrichtung 46 vorgegebenen definierten Nullpunkt, und mithin wird eine absolute Bildverschiebung durchgeführt.

Ein Vorgang zur Einstellung der absoluten Bildverschiebung wird insbesondere durch eine Sollwerteingabe von dem externen Sollwertgenerator 34 eingeleitet. Im ersten Verfahrensschritt wird über die Auswertungselektronik 32 anhand des vom Positionsdetektor 46 erhaltene Signals die Ansteuerungs- oder Drehungselektronik 38 der Platte 2 derart angesteuert, dass der reflektierte Teilstrahl 44 zur Mitte der Differenzdiode bewegt wird. Von diesem definierten Ausgangspunkt oder Referenzsignal wird in einem zweiten Verfahrensschritt die Platte 2 dann wiederum so lange und/oder weit in die angeforderte Richtung bewegt, bis das Ausgangssignal oder Zählsignal 30 der Interferometerelektronik 28, welches die Winkeländerung repräsentiert, dem Sollwert 36 entspricht. Je nach Art der verwendeten elektromagnetischen Strahlung des Messstrahls 18 oder der eingesetzten Detektoren des Positionsdetektors 46 können zusätzlich vor dem Positionsdetektor 46 für den zweiten Strahlanteil 42 auch noch Wellenfilter 50 und/oder Polarisationsfilter 52 angeordnet sein.

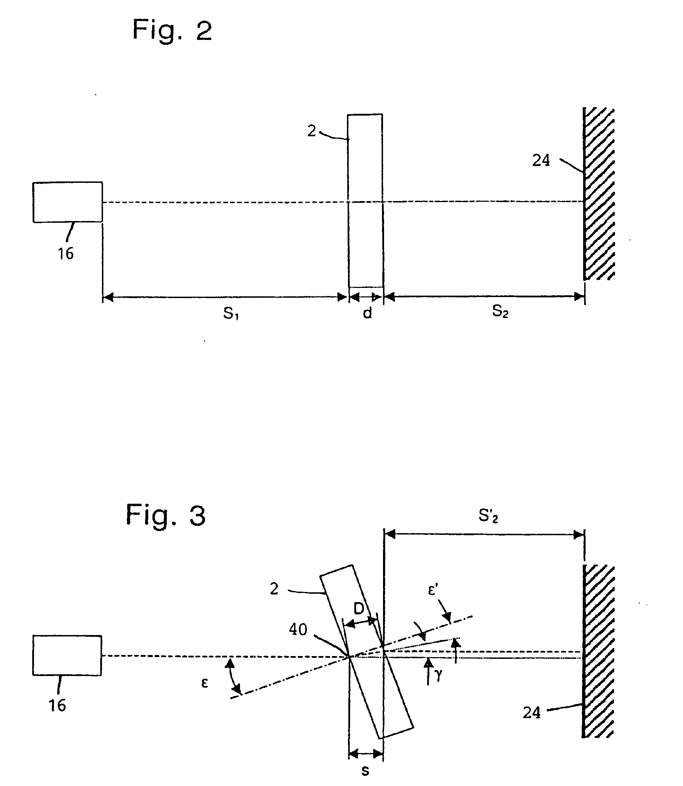

Im Folgenden wird die Methode der Winkeländerungsmessung mittels interferometrischer Messung der Weglängenänderung eines durch die planparallele Platte 2 laufenden Messstrahls 18 genauer erläutert, unter Verwendung der in den Fig. 2 und 3 dargestellten Formelzeichen. Die optische Weglänge des Messstrahls 18 ergibt sich aus dem Abstand von der Strahlquelle der Interferometeranordnung 16 zum Eintrittspunkt an der Platte 2, dem Weg innerhalb der Platte 2 und dem Weg zwischen Austrittspunkt aus der Platte 2 und dem Planspiegel 24, jeweils modifiziert mit der optischen Dichte der durchlaufenen Medien. Ohne Einschränkung der Allgemeinheit wird im Weiteren davon ausgegangen, dass außerhalb der planparallelen Platte 2 der Strahl durch Luft mit n=1 läuft. Sowohl die Weglänge innerhalb der Platte 2 als auch die zwischen Platte 2 und Spiegel 24 sind von der Winkelstellung der Platte 2 abhängig. Steht die Platte 2 gemäß Fig. 2 senkrecht zum einfallenden Strahl bzw. Messstrahl 18, kommt es zu keiner Strahlablenkung. Die Weglänge L ergibt sich aus den Abständen $S_1$ und $S_2$ entlang der Achse des einfallenden Strahls 18 und der Plattendicke d zu

$$L = S_1 + n_{Glas} \cdot d + S_2 .$$

Wird die Platte 2 gemäß Fig. 3 um die Drehachse 40 um einen Winkel $\varepsilon$ gedreht, wird dadurch der Strahl 18 innerhalb der Platte 2 um den Winkel $\gamma$ zu seiner Einfallsrichtung gebrochen. Er durchläuft die Platte 2 unter dem Winkel $\varepsilon'$ zum Lot, und der zurückgelegte Weg ist:

$$D = \frac{d}{\cos \varepsilon'} . \quad (1)$$

Die Strecke vom Austritt aus der Platte 2 zum Spiegel 24 ergibt sich zu

$$S_2' = S_2 + d - s,$$

wobei s die innerhalb der Platte 2 parallel zur ursprünglichen Achse zurückgelegte Strecke ist:

$$s = D\cos y = d\frac{\cos y}{\cos \varepsilon'} \quad (2)$$

Die optische Weglänge nach der Drehung ergibt sich zu:

$$L' = S_1 + n_{Glas} \cdot D + S_2 + d - s.$$

Der Unterschied der optischen Weglängen zwischen diesen beiden Fällen ist somit $\Delta L = L' - L = n_{Glas} \cdot (D - d) + d - s$, und durch Einsetzen der Gleichungen (1) und (2) und des Brechungsgesetzes $\sin \varepsilon = n_{Glas} \sin \varepsilon'$ sowie nachfolgendes Umformen ergibt sich daraus:

$$\Delta L = d\left(\sqrt{n_{Glas}^2 - \sin^2\varepsilon} + 1 - \cos\varepsilon - n_{Glas}\right)$$

Für hinreichend kleine Winkel $\varepsilon$ gilt näherungsweise:

$$\Delta L = d\left(\sqrt{n_{Glas}^2 - \sin^2\varepsilon} - n_{Glas}\right)$$

Die Änderung der optischen Weglänge in Abhängigkeit von der Änderung des Winkels wird aus der Ableitung dieses Zusammenhanges hergeleitet zu:

$$\frac{\partial \Delta L}{\partial \varepsilon} = d\sin\varepsilon\left(1 - \frac{\cos\varepsilon}{\sqrt{n_{Glas}^2 - \sin^2\varepsilon}}\right)$$

Bei einem Interferometer mit der Auflösung $x_{tic}$ werden somit bei einer Winkeländerung um $\Delta\varepsilon$

$$\Delta Z = \frac{d}{x_{tic}}\sin\varepsilon\left(1 - \frac{\cos\varepsilon}{\sqrt{n_{Glas}^2 - \sin^2\varepsilon}}\right)\Delta\varepsilon$$

Zählimpulse ausgelöst. Aus der benötigten Winkelstellung kann in der Regelelektronik, welcher in Fig. 1 das Bezugszeichen 32 zugeordnet ist, die Anzahl benötigter Impulse berechnet und die Bewegung entsprechend angesteuert werden.

Die erreichbare Auflösung in der Bildverschiebung ist begrenzt durch die Auflösung der Weglängenmessung durch das Interferometer und ergibt sich aus obigen Formeln unter Annahme kleiner Winkel zu:

$$\tau = \frac{x_{tic} \dfrac{n_{Glas} - 1}{n_{Glas}}}{\sin\varepsilon \left(1 - \dfrac{\cos\varepsilon}{\sqrt{n_{Glas}^2 - \sin^2\varepsilon}}\right)}$$

Diese Auflösung ist bei typischen Interferometerauflösungen von 9.89 nm deutlich höher als die z.B. bei einer Winkelmessung mittels Encoderscheibe erzielbare Auflösung.

**Bezugzeichen**

2    strahlungsbrechender Körper / planparallele Platte

4    Abbildungsoptik

6    Objekt

8    Bild

12   Winkelstellung von 2

14   Abbildungstrahl

16   Interferometeranordnung / Interferometereinheit

18   Messstrahl von 16

20   Winkel zwischen 14 und 18

22   erster Strahlanteil von 18

24   reflektierende Fläche / Planspiegel

26   interferometrisches Signal

28   Interferometerelektronik / Zähleinheit

30   Ausgangssignal von 28 / Istwert

32   Auswertungselektronik / Regler

34   externer Sollwertgenerator

36   Sollwertsignal

38   Ansteuerungselektronik / Drehungselektronik für 2

40     Drehachse von 2

42     zweiter Strahlanteil von 18

44     Eintrittsfläche / Oberfläche von 2

46     Messeinrichtung / Positionsdetektor

48     Positionssignal

50     Wellenlängenfilter

52     Polarisationsfilter

$S$,     Strecke von der Strahlungsquelle bis zum Eintrittspunkt des Meß- oder Licht- strahls 18 an der planparallelen Platte 2

$d$     Dicke der planparallelen Platte 2

$S_2$     Strecke vom Austrittspunkt an der aufrecht stehenden planparallelen Platte 2 bis zum Spiegel 24

$\varepsilon$     Winkel des einfallenden Strahles zum Lot, gleich dem Winkel des austretenden Strahles zum Lot der Eintrittsfläche oder Oberfläche 44

$\varepsilon'$     Winkel des in der Platte 2 laufenden Strahles zum Lot

$\gamma$     Winkel des in der Platte 2 laufenden Strahles zum einfallenden Strahl 18

$D$     Wegstrecke des Strahls innerhalb der planparallelen Platte 2

$s$     Projektion der Strahlwegstrecke in der planparallelen Platte 2 auf die Achse des einfallenden Strahls 18

$S_2'$     Strecke vom Austrittspunkt an der gekippten planparallelen Platte bis zum Spiegel 24

**Patentansprüche**

1. Verfahren zur Verschiebung eines durch elektromagnetische Strahlung (14) übertragenen Bildes (8) senkrecht zur Strahlungsrichtung mittels eines im Abbildungsstrahlverlauf befindlichen, drehbar angeordneten strahlungsbrechenden Körpers (2), welcher insbesondere als ein planparalleles Medium oder Glasplatte ausgebildet ist, mit einem Brechungsindex unterschiedlich zum umgebenden Medium bezüglich der verwendeten Strahlung, **dadurch gekennzeichnet, dass** die die Verschiebung verursachende Drehung des strahlungsbrechenden Körpers (2) dadurch gemessen wird, dass die durch die Winkeländerung in einem weiteren zur Messung genutzten elektromagnetischen Strahl (18) hervorgerufene Änderung der optischen Weglänge durch Auswertung der Überlagerung der von einer ebenen reflektierenden Fläche (24) zurückgeworfenen Strahlung mit der einfallenden elektromagnetischen Strahlung bestimmt wird, und dass ein Teil (42) des elektromagnetischen Messstrahls (18), der an der Oberfläche (44) des strahlungsbrechenden Körpers (2) reflektiert wird, auf eine Messeinrichtung (46) fällt, welche ein elektrisches Signal (48) in Abhängigkeit der Einfallsposition der elektromagnetischen Strahlung (18) liefert.

2. Verfahren nach Anspruch 1, wobei die Auswertung der Überlagerung der eingestrahlten (22) und der reflektierten Strahlung (42) durch Messung der Intensität des zeitlich konstanten Überlagerungsmusters wie zum Beispiel in einem Michelson Interferometer erfolgt oder durch Messung der zeitlichen Änderungen der Intensität des Überlagerungsmusters wie zum Beispiel in einem Heterodyne Interferometer erfolgt.

3. Verfahren nach Anspruch 1, wobei die Messeinrichtung (46), für die direkt reflektierte Strahlung (42) am strahlungsbrechenden Körper (2) das positionsabhängig elektrische Signal (48) aus der Differenz der Intensitäten aus mindestens zwei für elektromagnetischen Strahlung empfindlichen Detektoren bildet.

**4.** Verfahren nach Anspruch 1, wobei die Messeinrichtung (46), für die direkt reflektierte Strahlung (42) am strahlungsbrechenden Körper (2), das positionsabhängig elektrische Signal (48) direkt aus wenigstens einem für elektromagnetische Strahlung empfindlichen Detektor bildet.

**5.** Verfahren nach einem der Ansprüche 1 bis 4, wobei das Positionssignal (48) der Messeinrichtung (46) und das der Drehung und/oder Stellung des strahlungsbrechenden Körpers (2) entsprechende Signal (26) einer Auswertungselektronik oder Regelungselektronik (32) zugeführt werden.

**6.** Anordnung zur Durchführung des Verfahrens zur Verschiebung eines durch elektromagnetische Strahlung (14) übertragenen Bildes (8) senkrecht zur Strahlungsrichtung mittels eines im Abbildungsstrahlverlauf befindlichen, drehbar angeordneten strahlungsbrechenden Körpers (2), welcher insbesondere als ein planparalleles Medium oder Glasplatte ausgebildet ist, mit einem Brechungsindex unterschiedlich zum umgebenden Medium bezüglich der verwendeten Strahlung nach einem der Ansprüche 1 bis 5,
**dadurch gekennzeichnet,**
**dass** ein Interferometer (16) vorgesehen ist, mit welchem die die Verschiebung verursachende Drehung des strahlungsbrechenden Körpers (2) **dadurch** gemessen wird, dass die durch die Winkeländerung in einem weiteren zur Messung genutzten elektromagnetischen Strahl (2) hervorgerufene Änderung der optischen Weglänge durch Auswertung der Überlagerung der von einer ebenen reflektierenden Fläche (24) zurückgeworfenen Strahlung mit der einfallenden elektromagnetischen Strahlung bestimmt wird, und dass eine Messeinrichtung (46) vorgesehen ist, auf welche ein Teil (42) des elektromagnetischen Messstrahls (18) fällt, der an der Oberfläche (44) des strahlungsbrechenden Körpers (2) reflektiert wird, und welche ein elektrisches Signal (48) in Abhängigkeit der Einfallsposition der elektromagnetischen Strahlung liefert.

**7.** Anordnung nach Anspruch 6, wobei vor der Messeinrichtung (46), für die am strahlungsbrechenden Körper (2) direkt reflektierte Strahlung (42) ein wellenlängenabhängiger Filter (50) und/oder ein polarisationsabhängiger Filter (52) angebracht sind.

**8.** Anordnung nach Anspruch 6, wobei die Messeinrichtung (46) für die direkt reflektierte Strahlung (42) für elektromagnetische Strahlung empfindliche Detektoren enthält, mittels welchen aus der Differenz der Intensitäten das positionsabhängige Signal (48) gebildet wird.

**9.** Anordnung nach Anspruch 6, wobei die Messeinrichtung (46) für die direkt reflektierte Strahlung wenigstens einen für elektromagnetische Strahlung empfindlichen Detektor enthält, mittels welchem direkt das positionsabhängige Signal (48) gebildet wird.

**10.** Anordnung nach einem der Ansprüche 6 bis 9, wobei die Drehachse (40) des strahlungsbrechenden Körpers (2) zumindest näherungsweise durch dessen Oberfläche (44) verläuft, auf welche der Abbildungsstrahl (14) und/oder der Messstrahl (18) fallen, und/oder wobei der Abbildungsstrahl (14) und/oder der Messstrahl (18) zumindest näherungsweise die Drehachse (40) schneiden.

**Claims**

**1.** A method for the displacement of an image (8) transmitted by electromagnetic radiation (14) perpendicular to the direction of radiation by means of a rotatably disposed radiation-refracting body (2), which is located in the imaging beam path and which is particularly formed as a plane-parallel medium or a glass plate with a refractive index that differs from the surrounding medium in relation to the radiation used,
**characterised in that**
the rotation of the radiation-refracting body (2) causing the displacement is measured **in that** the change in optical path length caused by the angular change in a further electromagnetic beam (18) used for the measurement is determined by evaluating the superimposition of the radiation reflected back by a planar reflective surface (24) with the incident electromagnetic radiation and that part (42) of the electromagnetic measurement beam (18), which is reflected on the surface (44) of the radiation-refracting body (2), falls on a measuring device (46), which supplies an electrical signal (48) depending on the incident position of the electromagnetic radiation (18).

**2.** The method according to claim 1, wherein the evaluation of the superimposition of the irradiated (22) and reflected radiation (42) is achieved by measuring the intensity of the superimposition pattern constant in time as, for example, in a Michelson interferometer or by measuring the temporal changes in intensity of the superimposition pattern as, for example, in a heterodyne interferometer.

**3.** The method according to claim 1, wherein the measuring device (46) for the directly reflected radiation (42) at the radiation-refracting body (2) forms the position-dependent electrical signal (48) from the difference in intensities of at least two detectors sensitive to electromagnetic radiation.

**4.** The method according to claim 1, wherein the measuring device (46) for the directly reflected radiation (42) at the radiation-refracting body (2) forms the position-dependent electrical signal (48) directly from at least one detector sensitive to electromagnetic radiation.

**5.** The method according to one of the claims 1 to 4, wherein the position signal (48) of the measuring device (46) and the signal (26) corresponding to the rotation and/or position of the radiation-refracting body (2) are delivered to an evaluating or control electronic system (32).

**6.** An arrangement for carrying out the method for the displacement of an image (8) transmitted by electromagnetic radiation (14) perpendicular to the direction of radiation by means of a rotatably disposed radiation-refracting body (2), which is located in the imaging beam path and which is particularly formed as a plane-parallel medium or a glass plate with a refractive index that differs from the surrounding medium in relation to the radiation used according to one of the claims 1 to 5,
**characterised in that**
an interferometer (16) is provided, with which the rotation of the radiation-refracting body (2) causing the displacement is measured **in that** the change in optical path length caused by the angular change in a further electromagnetic beam (18) used for the measurement is determined by evaluating the superimposition of the radiation reflected back by a planar reflective surface (24) with the incident electromagnetic radiation and that a measuring device (46) is provided, on which part (42) of the electromagnetic measuring beam (18) falls, which is reflected on the surface (44) of the radiation-refracting body (2), and which supplies an electrical signal (48) depending on the incident position of the electromagnetic radiation.

**7.** The arrangement according to claim 6, wherein a wavelength-dependent filter (50) and/or a polarisation-dependent filter (52) are attached in front of the measuring device (46) for the directly reflected radiation (42) at the radiation-refracting body (2).

**8.** The arrangement according to claim 6, wherein the measuring device (46) for the directly reflected radiation (42) contains detectors sensitive to electromagnetic radiation, by means of which the position-dependent signal (48) is formed from the difference in intensities.

**9.** The arrangement according to claim 6, wherein the measuring device (46) for the directly reflected radiation contains at least one detector sensitive to electromagnetic radiation, by means of which the position-dependent signal (48) is directly formed.

**10.** The arrangement according to one of the claims 6 to 9, wherein the axis of rotation (40) of the radiation-refracting body (2) runs at least approximately through its surface (44), on which the imaging beam (14) and/or the measuring beam (18) fall and/or wherein the imaging beam (14) and/or the measuring beam (18) intersect the axis of rotation (40) at least approximately.

**Revendications**

**1.** Procédé pour déplacer une image (8) transmise par rayonnement électromagnétique (14) verticalement à la direction de rayonnement au moyen d'un corps réfractif (2) situé sur la trajectoire des rayons de reproduction, disposé de façon à pouvoir tourner et réalisé en particulier comme un milieu ou une plaque de verre à faces planes et parallèles, avec un indice de réfraction différent du milieu ambiant par rapport au rayonnement utilisé,
**caractérisé en ce**
**que** la rotation du corps réfractif (2), qui provoque le déplacement, est mesurée en ce que la modification de la longueur de trajet optique, provoquée par la modification d'angle dans un autre rayon électromagnétique (18) utilisé pour la mesure, est déterminée par une évaluation de la superposition du rayonnement réfléchi par une surface réfléchissante plane (24) avec le rayonnement électromagnétique incident, et en ce qu'une partie (42) du rayon de mesure électromagnétique (18), qui est réfléchie à la surface (44) du corps réfractif (2), tombe sur un dispositif de mesure (46) qui fournit un signal électrique (48) en fonction de la position d'incidence du rayonnement électromagnétique (18).

2. Procédé selon la revendication 1, dans lequel l'évaluation de la superposition du rayonnement incident (22) et du rayonnement réfléchi (42) s'effectue par la mesure de l'intensité du motif de superposition constant dans le temps, comme par exemple dans un interféromètre de Michelson, ou par la mesure des modifications dans le temps de l'intensité du motif de superposition, comme par exemple dans un interféromètre hétérodyne.

3. Procédé selon la revendication 1, dans lequel le dispositif de mesure (46) forme pour le rayonnement réfléchi (42) directement au niveau du corps réfractif (2) le signal électrique (48) en fonction de la position à partir de la différence des intensités provenant d'au moins deux détecteurs sensibles au rayonnement électromagnétique.

4. Procédé selon la revendication 1, dans lequel le dispositif de mesure (46) forme pour le rayonnement réfléchi (42) directement au niveau du corps réfractif (2) le signal électrique (48) en fonction de la position directement à partir d'au moins un détecteur sensible au rayonnement électromagnétique.

5. Procédé selon l'une quelconque des revendications 1 à 4, dans lequel le signal de position (48) du dispositif de mesure (46) et le signal (26) correspondant à la rotation et/ou à la position du corps réfractif (2) sont amenés à une électronique d'évaluation ou à une électronique de régulation (32).

6. Ensemble permettant d'exécuter le procédé de déplacement d'une image (8) transmise par un rayonnement électromagnétique (14) verticalement à la direction de rayonnement au moyen d'un corps réfractif (2) situé sur la trajectoire des rayons de reproduction, disposé de façon à pouvoir tourner et réalisé en particulier comme un milieu ou une plaque de verre à faces planes et parallèles, avec un indice de réfraction différent du milieu ambiant par rapport au rayonnement utilisé, selon l'une quelconque des revendications 1 à 5,
**caractérisé en ce
qu'**un interféromètre (16) est prévu par lequel la rotation du corps réfractif (2) qui provoque la translation est mesurée en ce que la modification de la longueur de trajet optique, provoquée par la modification d'angle dans un autre rayon électromagnétique (2) utilisé pour la mesure, est déterminée par une évaluation de la superposition du rayonnement réfléchi par une surface réfléchissante plane (24) avec le rayonnement électromagnétique incident, et en ce qu'un dispositif de mesure (46) est prévu sur lequel tombe une partie (42) du rayon de mesure électromagnétique (18) qui est réfléchie à la surface (44) du corps réfractif (2), et qui fournit un signal électrique (48) en fonction de la position d'incidence du rayonnement électromagnétique.

7. Ensemble selon la revendication 6, dans lequel, pour le rayonnement (42) réfléchi directement au niveau du corps réfractif (2), un filtre (50) en fonction de la longueur d'onde et/ou un filtre (52) en fonction de la polarisation est/sont aménagé(s) avant le dispositif de mesure (46).

8. Ensemble selon la revendication 6, dans lequel le dispositif de mesure (46) comprend des détecteurs sensibles au rayonnement électromagnétique pour le rayonnement réfléchi (42) directement, lesdits détecteurs permettant de former le signal en fonction de la position (48) à partir de la différence des intensités.

9. Ensemble selon la revendication 6, dans lequel le dispositif de mesure (46) comprend pour le rayonnement réfléchi directement au moins un détecteur sensible au rayonnement électromagnétique qui permet de former directement le signal en fonction de la position (48).

10. Ensemble selon l'une quelconque des revendications 6 à 9, dans lequel l'axe de rotation (40) du corps réfractif (2) s'étend au moins approximativement à travers la surface (44) de celui-ci, sur laquelle tombe(nt) le rayonnement de reproduction (14) et/ou le rayon de mesure (18), et/ou dans lequel le rayon de reproduction (14) et/ou le rayon de mesure (18) coupe(nt) au moins approximativement l'axe de rotation (40).

Fig. 1

# Fig. 2

# Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5625436 A
- US 5218415 A
- DE 3820170 A1
- DD 239658 A1